# FASCICULE DE BREVET EUROPEEN

(11) **EP 1 138 101 B1**
(45) Date de publication et mention de la délivrance du brevet: **29.01.2003**
(21) Numéro de dépôt: 99955634.3
(22) Date de dépôt: 30.11.1999
(51) Int. Cl.: H01S 5/34

(54) **LASER DE TYPE SEMI-CONDUCTEUR**
HALBLEITERLASER
SEMICONDUCTOR LASER

(30) Priorité: 09.12.1998 FR 9815721
(43) Date de publication de la demande: 04.10.2001
(73) Titulaire: Alpes Lasers SA, 2000 Neuchâtel (CH)
(72) Inventeur: FAIST, Jérôme, CH-2000 Neuchâtel (CH); BECK, Mattias, CH-2000 Neuchâtel (CH); MULLER, Antoine, CH-2000 Neuchâtel (CH)
(74) Mandataire: Gresset, Jean
(86) Numéro de dépôt international: CH9900572
(87) Numéro de publication internationale: WO00035060

(56) Documents cités:
- EP-A- 0 877 454
- TREDICUCCI A ET AL: "HIGH-POWER INTER-MINIBAND LASING IN INTRINSIC SUPERLATTICES" APPLIED PHYSICS LETTERS, vol. 72, no. 19, 11 mai 1998 (1998-05-11), pages 2388-2390, XP000755970 ISSN: 0003-6951 cité dans la demande
- GMACHL C ET AL: "CONTINUOUS-WAVE AND HIGH-POWER PULSED OPERATION OF INDEX-COUPLED DISTRIBUTED FEEDBACK QUANTUM CASCADE LASER AT LAMBDA=8.5 MUM" APPLIED PHYSICS LETTERS, vol. 72, no. 12, 23 mars 1998 (1998-03-23), pages 1430-1432, XP000742875 ISSN: 0003-6951

## Description

La présente invention se rapporte aux lasers de type semi-conducteur émettant dans une bande comprise dans l'infrarouge. On relèvera que les définitions des termes techniques et scientifiques utilisés et la plupart des phénomènes physiques mentionnés dans le présent document sont expliqués dans l'ouvrage intitulé "Quantum electronics" de Anmon Yariv, éditions J. Wiley, New-York 1989.

La présente invention concerne, plus particulièrement, un laser semi-conducteur de type unipolaire, comportant un substrat et un empilement de couches qui définissent ensemble:
- une région de gain comprenant au moins:
   - une zone active avec au moins un puits quantique permettant des transitions inter-sous-bandes de porteurs de charge susceptibles de générer des photons de lumière cohérente,
   - une zone d'injection attenante à la zone active,
- deux couches de confinement optique entre lesquelles la région de gain est interposée et qui définissent ensemble un guide d'ondes, et
- deux électrodes disposées aux extrémités respectives de l'empilement, pour l'application d'un champ électrique.

Dans les lasers de type unipolaire, l'émission de photons fait appel à des porteurs de charge d'un seul type, en général des électrons. Un tel laser est, par exemple, décrit dans la revue Science, May 1997, Volume 75, pp. 773-776, dans un article intitulé "High-Power Infrared (8-Micrometer Wavelength) Supperlattice Lasers".

Ce laser comporte un substrat sur lequel on dépose des couches alternées de deux semi-conducteurs, qui définissent respectivement des puits et des barrières quantiques et forment au moins une zone active dans laquelle s'effectuent les transitions inter-sous-bandes, et une zone d'injection permettant d'injecter des électrons dans la zone active. Les zones actives sont agencées de manière qu'elles comportent deux sous-bandes entre lesquelles les électrons peuvent transiter, le passage de la sous-bande supérieure à la sous-bande inférieure générant des photons de lumière cohérente.

Le pompage des électrons dans la sous-bande supérieure est rendu possible par l'application d'un champ électrique dans la zone d'injection, au moyen des électrodes placées de part et d'autre de l'empilement.

Pour obtenir une telle émission avec un rendement satisfaisant, il est nécessaire que le champ à l'intérieur de la zone active soit aussi faible que possible, ceci afin d'augmenter la force d'oscillateur, ce qui améliore le rendement et la durée de vie des électrons dans la sous-bande, de manière à pouvoir travailler à des températures aussi élevées que possible.

Une première solution permettant de réduire le champ consiste à doper la zone active de manière que sa résistivité soit la plus faible possible. Elle a été décrite par Scamarcio et al. (Science 76, pp. 773 - 776 / 1997). Si le champ électrique est ainsi considérablement réduit dans cette zone, la présence de dopant engendre malheureusement un élargissement significatif de la transition optique et donc une augmentation du courant de seuil.

Une autre solution est décrite par Tredicucci et al. (Appl. Phys. Lett. 72, pp 2388-2390 / 1998). Un plan dopé, de type n, est intercalé entre la zone d'injection et la zone active. On transfère ainsi des électrons libres du plan de dopage à un réservoir de porteurs. Ces électrons ne participent pas à l'effet laser. Ils vont donc augmenter les pertes optiques.

Dans une troisième solution, proposée par Tredicucci et al. (Appl. Phys. Lett. 73, p. 101-103 / 1998), la zone active comporte un superréseau formé d'un empilement de strates en alliages semi-conducteurs qui définissent une alternance de puits et de barrières quantiques. Dans cette zone, on compense le champ électrique appliqué par un "quasi-champ" généré par la structure modulée du superréseau. En d'autres termes, on amène le potentiel des sous-bandes à un niveau quasi-constant en ajustant la largeur des puits et des barrières.

Avec cette solution, la force d'oscillateur est réduite du fait que le champ appliqué brise la périodicité du réseau et localise les fonctions d'ondes sur une distance nettement inférieure à la largeur du superréseau (un à trois puits). De plus, lorsque le champ électrique appliqué est élevé, ce qui l'est d'autant plus que la longueur d'onde du rayonnement émis est courte, l'épaisseur du superréseau est limitée.

Le but principal de la présente invention est de réaliser des lasers de type semi-conducteur à puits quantique permettant des transitions inter-sous-bandes, dans lesquels le champ à l'intérieur de la zone active est minimisé, sans pour autant affecter les autres paramètres.

Ce but est atteint grâce au fait que, dans le laser selon l'invention, la région de gain comporte, en outre, deux plans de dopage, l'un de type p, donneur de trous ou receveur d'électrons et l'autre de type n, donneur d'électrons ou receveur de trous, disposés de part et d'autre de la zone active, le plan de dopage du type donneur étant intercalé entre la zone active et la zone d'injection.

Le rendement figure parmi les caractéristiques les plus importantes des lasers. Or, la pratique a montré que les pertes les plus fortes se produisent dans les couches comprises entre les électrodes et la région active. Pour réduire l'importance de ces pertes, on augmente la dimension relative de la région active par rapport aux zones périphériques.

A cet effet, il est avantageux que la région de gain comporte une pluralité de zones actives et de zones d'injection disposées en alternance et définissant une structure en cascade, chaque zone active étant interposée entre deux plans de dopage.

Dans le but toujours d'augmenter la puissance disponible, chaque zone active est formée de strates définissant un superréseau comportant une alternance de barrières et de puits quantiques.

Afin de réaliser une structure présentant un minimum de défauts, ceux-ci affectant le rendement du laser, il est avantageux d'utiliser un substrat monocristallin de phosphure d'indium (InP) et des couches de confinement en un alliage (InGaAs) d'arséniure d'indium (InAs) et d'arséniure de gallium (GaAs). En outre, les strates de la région active définissant les barrières sont en un alliage (AlInAs) d'arséniure d'aluminium (AlAs) et de InAs, alors que les strates définissant les puits sont en InGaAs.

De manière particulièrement avantageuse, l'alliage de InGaAs comporte une proportion de 52% molaire de InAs et 48% de GaAs, alors que l'alliage de AlInAs comporte une proportion de 53% molaire de InAs et 47% de AlAs. De la sorte, les mailles des réseaux cristallins du substrat, des couches de confinement et de la région de gain sont accordées.

Ainsi que cela a été expliqué plus haut, certaines parties du laser doivent être dopées. De bons résultats ont été obtenus en utilisant du silicium comme dopant de type n et du béryllium ou du carbone comme dopant de type p.

L'expérience a montré que la densité du dopant ne présente pas de seuil, mais varie au contraire de façon progressive, la diffusion du béryllium étant plus importante que celle du silicium. Or, la présence de dopant dans la zone active affecte sensiblement le rendement du laser. Pour pallier cet inconvénient, un mode particulier de réalisation du laser selon l'invention comporte, sur le substrat, un empilement dans l'ordre suivant:
- plan dopé de type n,
- zone active,
- plan dopé de type p,
- zone d'injection.

Pour obtenir un laser de qualité, la couche de confinement se trouvant du côté opposé au substrat est recouverte d'une couche tampon en AlInAs, à faible indice de réfraction.

Afin de faciliter l'injection de charges dans la structure, et plus particulièrement pour éviter un seuil de potentiel entre les électrodes et le guide d'ondes, le laser comporte, en outre, entre chacune des couches de confinement optique et l'électrode qui lui est contiguë, une région de gradation formée d'une alternance de barrières et de puits dont les épaisseurs sont modulées.

Dans certaines applications, il est nécessaire de disposer d'un laser émettant dans une longueur d'onde très étroite. Or, la bande dans laquelle émettent les lasers tels que définis ci-dessus présente une largeur relativement importante, due aux caractéristiques dimensionnelles des zones actives.

Pour résoudre ce problème, l'une des couches de confinement comporte un réseau périodique de découpes ayant un pas égal à un multiple de la moitié d'une longueur d'onde comprise dans la bande passante de la lumière émise dans la zone active. Dans une première variante, les découpes sont obturées au moyen d'un métal, par exemple une couche de titane recouverte d'une couche d'or, pouvant former l'une des électrodes. Dans une seconde variante, les découpes sont obturées au moyen d'un diélectrique, par exemple du phosphure d'indium ou du nitrure de silicium.

Dans l'une comme dans l'autre de ces variantes, on favorise une longueur d'onde définie par les caractéristiques du réseau, nettement plus étroite que celle obtenue avec les lasers antérieurement définis.

De manière avantageuse, les porteurs de charges sont des électrons.

D'autres avantages et caractéristiques de l'invention ressortiront de la description qui va suivre, faite en regard du dessin annexé, dans lequel:
- La figure 1 représente, de manière schématique, la structure d'un laser selon l'invention;
- La figure 2 est un diagramme montrant la variation de la force d'oscillateur, d'une part et du produit de la force d'oscillateur et du temps de vie de l'état fondamental de la sous-bande supérieure d'un superréseau périodique, d'autre part, en fonction du champ électrique appliqué dans la région de gain;
- La figure 3 illustre, de manière schématique, un profil de bandes d'énergie dans une portion de structure comprenant deux zones d'injection entourant une zone active et dans laquelle est appliqué un champ électrique F_{moy}:
   - en a, comme si les plans dopés n'avaient pas encore libéré leurs charges,
   - en b, après libération des charges;
- La figure 4 montre la densité des dopants dans la portion de structure telle que représentée à la figure 2;
- La figure 5 représente, d'une part, la tension appliquée et d'autre part, la puissance optique dispensée en fonction du courant électrique injecté; et
- La figure 6 montre un spectre optique d'un laser selon l'invention.

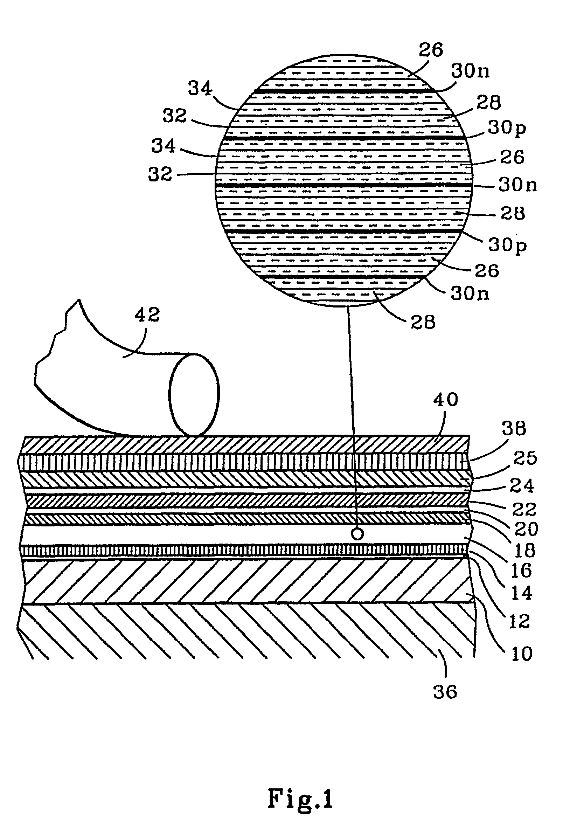

La figure 1 représente schématiquement, et à titre d'exemple, la structure d'un laser selon l'invention, de type unipolaire et dans lequel les électrons sont les porteurs de charge. Sur cette figure, les échelles ne peuvent pas être respectées, à cause des épaisseurs particulièrement faibles de certaines couches. Le laser représenté comporte un substrat 10 en phosphure d'indium (InP) monocristallin, tenant lieu d'électrode, et sur lequel sont empilées des couches successives, à savoir
- une première région de gradation 12, destinée à éviter la présence d'un seuil de potentiel,
- une première couche de confinement optique 14, à fort indice de réfraction,
- une région de gain 16,
- une seconde couche de confinement optique 18,
- une deuxième région de gradation 20,
- une zone tampon 22 à faible indice de réfraction,
- une troisième région de gradation 24, et
- une électrode 25.

Ainsi qu'on peut le voir sur la partie agrandie de la figure 1, la région de gain 16 est formée d'une succession de zones actives 26 et de zones d'injection 28, séparées par des plans de dopage 30, avec un plan de dopage de type n, portant la référence 30n, et un plan de dopage de type p, désigné par 30p, disposés de part et d'autre de chaque zone active 26. Le plan de dopage de type n est intercalé entre la zone active 26 et la zone d'injection 28 de laquelle proviennent les porteurs de charges, en l'occurrence les électrons actifs. Chacune de ces zones est elle-même réalisée au moyen d'une alternance de strates d'alliages d'arséniure de gallium et d'indium (InGaAs), d'une part, d'arséniure d'aluminium et d'indium (AlInAs), d'autre part, dont les fonctions seront précisées plus loin.

Le substrat 10 est soudé sur un support en cuivre 36. L'électrode 25 est recouverte d'une couche de nitrure de silicium 38 (Si₃N₄), puis d'une métallisation 40, de titane et/ou d'or, sur laquelle un fil d'or 42 est soudé. L'alimentation électrique du laser représenté est réalisée par le branchement du support 36 et de la métallisation 40, par l'intermédiaire du fil 42, à une source d'énergie électrique de type continu, non représentée au dessin.

La fabrication du laser tel que décrit fait essentiellement appel à la technique dite de croissance épitaxiale par jet moléculaire, connue sous l'abréviation "MBE", de l'anglais "Molecular Beam Epitaxy". Cette technique permet de déposer des couches extrêmement minces, indispensables pour obtenir les effets quantiques souhaités.

Le tableau 1 ci-après précise les caractéristiques de chacune des couches formant le laser de la figure 1.

**Tableau 1**

| **Référence** | **Matériau** | **Dopant** | **Niveau de dopage [cm**^{**-3**}**]** | **Epaisseur [nm]** |
|---|---|---|---|---|
| Substrat 10 | InP | Si | 2.00E+17 | massif |
| Première région de gradation 12 | GaAlInAs | Sl | 2.00E+17 | 25 |
| Première couche confinement optique 14 | InGaAs | Si | 6.00E+16 | 700 |
| Région de gain 16 | GaAlInAs | Détail: voir tableau 2 | | 2032,5 |
| Second couche confinement optique 18 | InGaAs | Si | 6.00E+16 | 800 |
| Deuxième région de gradation 20 | GaAlInAs | Si | 2.00E+17 | 30 |
| Zone tampon 22 | AlInAs | Si | 1.00E+18 | 10 |
| | AlInAs | Si | 1.50E+17 | 1050 |
| | AlInAs | Si | 1.00E+18 | 10 |
| Troisième région de gradation 24 | GaAlInAs | Si | 5.00E+18 | 30 |
| Electrode 25 | InGaAs | Si | 7.00E+18 | 1050 |
| | InGaAs | Si | 5.00E+19 | 10 |

De manière plus précise, la région de gain 16 comprend vingt-cinq couches identiques, formées chacune d'une zone d'injection 28 et d'une zone active 26, elles-mêmes constituées de strates qui définissent une alternance de puits 32 et de barrières quantiques 34, respectivement constituées d'alliages de InGaAs et de AlInAs. Les plans de dopage 30n et 30p sont réalisés aux interfaces des zones actives et des zones d'injection en ajoutant du silicium ou du béryllium à l'alliage formant le ou les strates concernées. Le tableau 2 ci-dessous définit la structure de ces couches et la concentration en dopant.

**Tableau 2**

| **Référence** | **Matériau** | **Dopant** | **Niveau de dopage** | **Epaisseur [nm]** |
|---|---|---|---|---|
| Zone d'injection 28 | | | | |
| | AlInAs | | | 1,6 |
| | InGaAs | | | 4,4 |
| | AlInAs | | | 1,8 |
| | InGaAs | | | 3,8 |
| | AlInAs | | | 2,0 |
| | InGaAs | | | 3,4 |
| | AlInAs | | | 2,3 |
| | InGaAs | | | 2,8 |
| | AlInAs | | | 2,4 |
| | InGaAs | | | 2,5 |
| | AlInAs | | | 2,5 |
| Plan de dopage 30n | InGaAs | Si | 1.00E+18 | 2,4 |
| | AlInAs | Si | 1.00E+18 | 2,6 |
| | InGaAs | Si | 1.00E+18 | 2,3 |
| Zone active 26 | AlInAs | | | 4,0 |
| | InGaAs | | | 5,9 |
| | AlInAs | | | 0,8 |
| | InGaAs | | | 5,9 |
| | AlInAs | | | 0,8 |
| | InGaAs | | | 5,9 |
| | AlInAs | | | 0,8 |
| | InGaAs | | | 5,9 |
| | AlInAs | | | 0,8 |
| | InGaAs | | | 5,9 |
| | AlInAs | | | 3,0 |
| Plan de dopage 30p | InGaAs | Be | 9.00E+17 | 4,8 |

Pour garantir le bon fonctionnement du laser, il est nécessaire que la structure monocristalline soit assurée dans toute son épaisseur. L'une des conditions est que les mailles du réseau cristallin soient constantes. A cet effet, les strates définissant les puits, en alliage d'arséniure d'indium et de gallium, sont formées à 52% molaire d'arséniure d'indium et 48% d'arséniure de gallium. De même, les strates définissant les barrières, en alliages d'arséniure d'aluminium et d'indium, sont formées à 53% molaire d'arséniure d'indium et 47% d'arséniure d'aluminium.

Afin que la lumière engendrée par le laser puisse être utilisée de manière adéquate, il est nécessaire que la région de gain 16 forma un guide d'ondes dans lequel elle est confinée. A cet effet, les couches de confinement optique 14 et 18, en InGaAs dopé dont l'indice de réfraction est égal à 3,5, sont disposées de part et d'autre de la région de gain 16, dont l'indice de réfraction est égal à 3,4 environ.

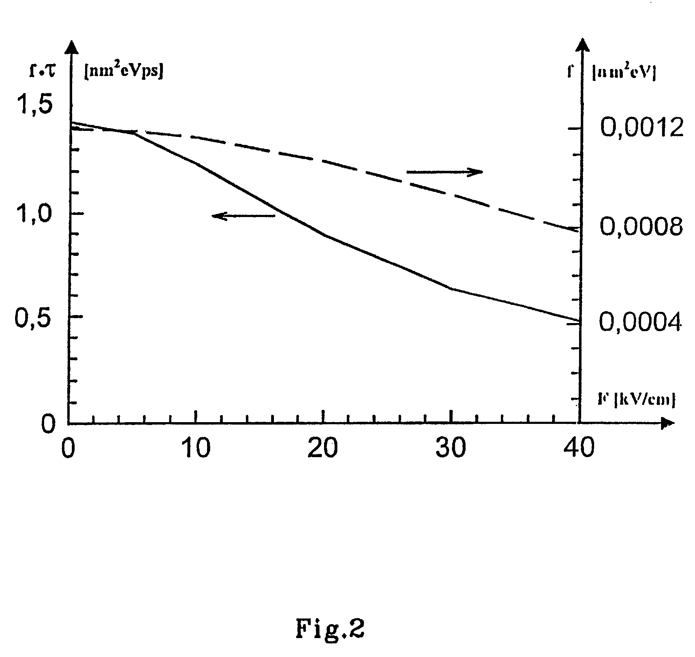

En se référant à la figure 2, on peut voir la variation de la force d'oscillateur f et la variation du produit f.τ de la force d'oscillateur f par le temps de vie τ de l'état fondamental de la sous-bande supérieure d'un superréseau périodique, en fonction de la valeur du champ F dans les zones actives.

Le pompage des porteurs de charges, qui permet l'inversion de population conduisant à une émission laser, nécessite l'application d'un champ électrique compris sensiblement entre 20 et 40 kV/cm dans les zones d'injection. Il apparaît sur cette figure que, dans cette plage, la force d'oscillateur f diminue d'un facteur compris entre 10 et 30% environ. La chute du produit f.τ est encore plus forte, variant de 30 à 70%. En d'autres termes, le rendement du laser est donc considérablement réduit si le champ n'est pas supprimé dans les zones actives.

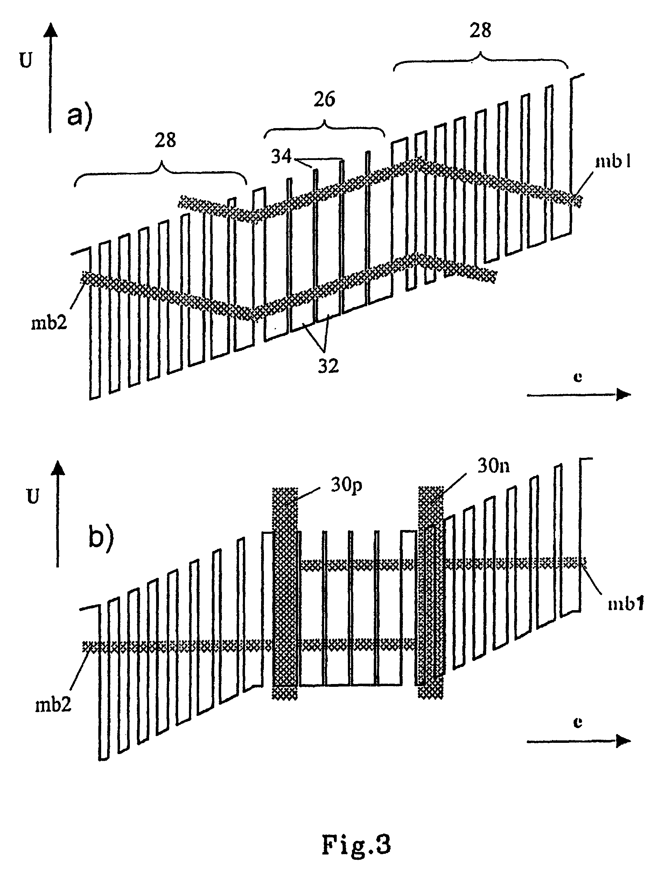

Pour bien comprendre le principe de fonctionnement du laser selon l'invention, il faut se référer aux figures 3a et 3b, qui montrent la variation de potentiel U dans une portion de l'épaisseur e la région de gain, et plus particulièrement une zone active 26 intercalée entre deux zones d'injection 28. Sur ces figures, on considère que le laser est soumis à une tension électrique appliquée à ses bornes, qui génère un champ électrique F_{moy}. La courbe de potentiel présente une structure en créneaux, correspondant aux strates représentées à la figure 1 et qui définissent respectivement les puits 32 et les barrières 34. La différence de potentiel entre puits et barrières est définie par la composition des strates les constituant. On a, en outre, représenté en grisé les sous-bandes, référencées mb1 et mb2, entre lesquelles transitent les électrons.

Sur la figure 3a, on montre la variation de potentiel d'une région de gain dans laquelle on n'aurait pas introduit de moyens en vue de supprimer le champ dans les zones actives, ou dans laquelle les dopants n'auraient pas libéré leurs charges. Il en résulte que le champ F_{moy}, qui correspond à la pente de la courbe, est constant. Dans les zones d'injection 28, l'épaisseur des strates est modulée de manière que la sous-bande inférieure d'une zone active soit reliée à la sous-bande supérieure de la zone active suivante. A cet effet, l'épaisseur des strates formant les puits 32 augmente et celle des strates formant les barrières 34 diminue lorsqu'on se déplace dans une zone dans la direction substrat-surface.

Comme on peut le voir sur la figure 3a, dans une sous-bande donnée, le potentiel croît dans les zones d'injection lorsqu'on va de la droite vers la gauche. Ainsi, les zones d'injection ne peuvent pas remplir leur fonction, les électrons devant vaincre une différence de potentiel pour passer d'une zone active à la suivante.

Dans les zones actives, la largeur des barrières et des puits est constante, de sorte que la position des sous-bandes reste la même par rapport au fond des puits. En d'autres termes, le potentiel décroît lorsqu'on se déplace de la droite vers la gauche. De ce fait, les électrons ont tendance à se concentrer dans la partie gauche de la zone active, au niveau mb2, la zone active et la zone d'injection définissant une cuvette dans laquelle les électrons restent piégés.

La figure 3b montre la variation de potentiel telle qu'elle se présente effectivement dans le laser selon l'invention. En plus de la courbe de potentiel et des sous-bandes représentées à la figure 3a, on peut voir les zones occupées par les plans de dopage 30n et 30p.

Comme cela est défini dans le tableau 2, le plan 30p est obtenu en introduisant des atomes de béryllium dans le jet moléculaire lors du dépôt de la dernière strate de chaque zone active, alors que le plan 30n est obtenu en ajoutant des atomes de silicium lors du dépôt des trois dernières strates de chaque zone d'injection. En créant ces plans de dopages 30n et 30p, on engendre des dipôles locaux, amarrés dans la structure, qui vont soit s'opposer au champ appliqué, soit au contraire s'y additionner. On obtient ainsi un superréseau à potentiel constant dans les zones actives 26 et une augmentation de la différence de potentiel dans les zones d'injection 28. De la sorte, le potentiel des sous-bandes mb1 et mb2 représentées est pratiquement constant, ce qui permet le pompage et le saut de charges engendrant l'émission laser.

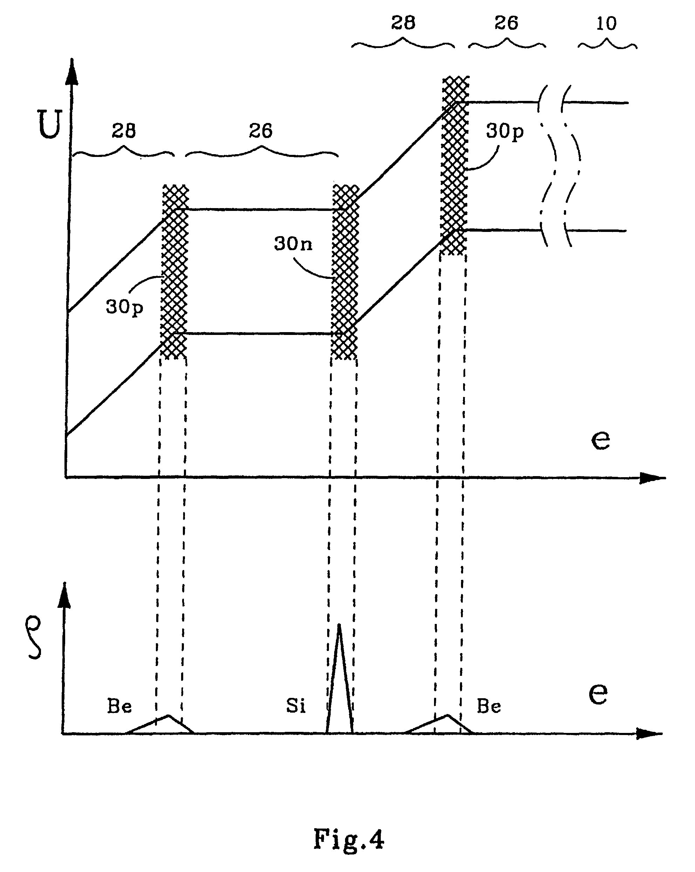

On relèvera ici que, même si le béryllium n'est déposé que dans la dernière strate de la région de gain, il se retrouve dans les strates voisines et plus particulièrement dans celles déposées ultérieurement, ainsi qu'on peut le voir sur la figure 4. Cette figure montre, en a et de manière schématique, la variation de potentiel correspondant à la figure 3b, et en b la densité ρ de dopant dans les strates des zones actives et d'injection. Le substrat 10 se trouve sur la droite de la figure.

La diffusion est moins marquée avec le silicium. Comme cela a été expliqué plus haut, il faut que la zone active comporte le moins possible d'impuretés. C'est pourquoi, il est préférable de déposer le dopant le plus diffusant dans la dernière strate de la zone active, plutôt que dans la première.

Les densités N_{d} de dopant de type n (donneur) et Nₐ de type p (accepteur) sont choisies de manière que le dipôle engendré compense le champ F_{moy} induit par le potentiel appliqué aux bornes du laser.

De manière plus précise, on peut agir sur la configuration du champ généré par les charges en ajustant la densité de dopant de l'un et l'autre types. Cela permet d'ajuster la densité des charges fixes positives et négatives ainsi que celle des charges mobiles et, par là, définir la conductivité dans la région de gain et le champ F tant dans les zones actives que dans les zones d'injection.

Des essais pratiques ont été réalisés avec des lasers tels que définis et décrits ci-dessus. Chaque laser, de 1,5 mm de longueur, est obtenu par clivage à partir d'un même substrat. Les mesures sont faites dans un cryostat à flux d'hélium dont la température peut être comprise entre 5 et 320°K. Les lasers sont alimentés par des impulsions de courant de 100 ns, à une fréquence de 5 kHz. Une lentille asphérique en germanium, dont l'ouverture est de F/0.8, focalise la lumière sur un détecteur de type HgCdTe calibré et fonctionnant à 77°K.

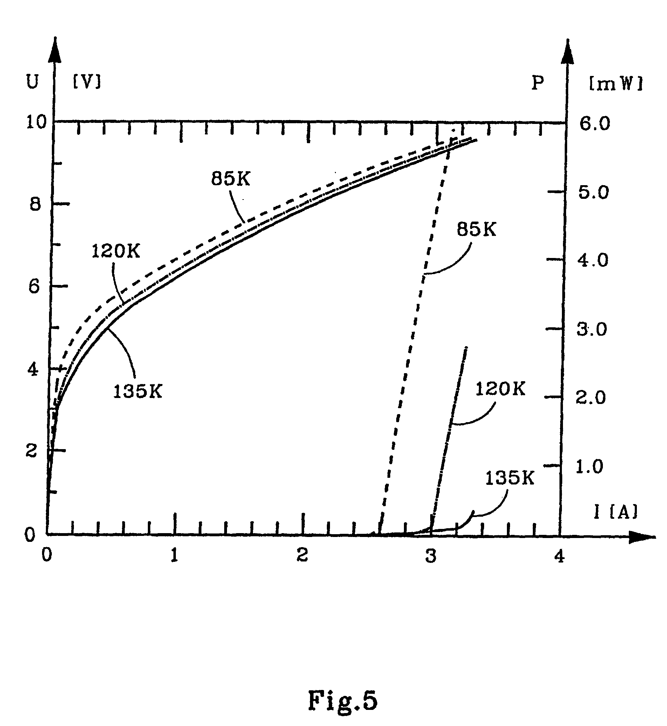

La figure 5 montre les résultats obtenus, et plus particulièrement la variation de la tension appliquée U et de la puissance optique P en fonction du courant injecté I, cela pour des températures de travail de 85°K, 120°K et 135°K. On peut voir, de manière particulièrement nette, les seuils de courant au-delà desquels le laser émet, le niveau du seuil augmentant avec la température.

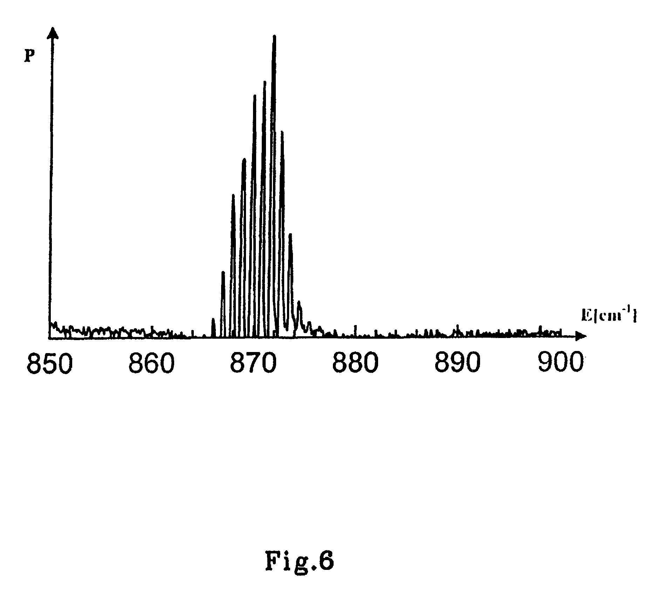

Le diagramme de la figure 6 représente le spectre d'émission en fonction de l'énergie des photons E, qui montre de manière très claire, à cause de l'étroitesse du pic, qu'il s'agit bien là d'un laser.

La lumière émise par ce laser a une longueur d'onde de 11 µm, située donc dans l'infra-rouge moyen.

Ainsi, grâce au fait que deux plans de dopage sont associés à chaque zone active, il est possible de réaliser des lasers semi-conducteurs à transition inter-sous-bandes dans lesquels le champ dans les zones actives est pratiquement nul.

Le laser, tel que décrit à titre d'exemple, permet de nombreuses variantes. On peut notamment réaliser une structure en cascade comportant plus ou moins d'étages, ou encore renoncer au superréseau. On peut en outre modifier la longueur d'onde du rayonnement émis par un changement de l'épaisseur des puits de potentiel dans la ou les zones actives.

Dans une variante particulièrement avantageuse, on peut combiner les caractéristiques du laser selon l'invention avec celles définies dans la troisième solution évoquée ci-dessus et proposée par Trediccuci et al. dans Appl. Phys. Lett. 73. Dans cette variante, on combine la présence de deux plans de dopage placés de part et d'autre de chaque zone active avec, dans ces zones, des strates formant les puits et les barrières qui ont des épaisseurs modulées. On obtient ainsi une configuration optimale en réduisant la densité de dopant, tout en évitant une gradation trop importante dans les zones actives.

Pour certaines applications, il est nécessaire que la lumière émise par le laser ait une fréquence très précise. Or, la largeur du spectre émis par le laser tel qu'il vient d'être décrit, fonction des caractéristiques dimensionnelles des strates, ne peut être que partiellement maîtrisée. Pour réduire cette largeur, il est possible de réaliser un réseau à la proximité de la région active.

Dans un premier mode de réalisation, la couche de confinement comporte des trous, disposés en un réseau et espacés d'une distance égale à un multiple de la moitié d'une longueur d'onde comprise dans la bande passante du laser. Ces trous, pratiqués par lithographie et attaque chimique, sont obturés par un métal, par exemple de l'or, qui peut, en outre, tenir lieu d'électrode. Le livre mentionné plus haut, intitulé "Quantum Electronics", décrit au chapitre 22.4 un laser présentant cette caractéristique. Dans ce cas, le mode sélectionné est forcé par absorption.

Dans un second mode de réalisation, on remplace le métal par un diélectrique. Une solution de ce type est, par exemple, décrite dans l'ouvrage intitulé "Optoélectronique" de E. Rosencher et B. Masson, chap. 13, Paris 1998. Le mode sélectionné est alors forcé par un phénomène physique faisant appel à la réflexion.

En ajustant la largeur des puits dans les zones actives, il est possible de modifier cette longueur d'onde, dans un intervalle typiquement compris entre 3,5 et 12 µm. Cet intervalle correspond sensiblement à la plage d'absorption fondamentale des molécules organiques. Les lasers tels que définis sont donc particuliérement bien adaptés pour détecter la présence de telles molécules dans une solution, aussi bien pour effectuer des mesures par photo-excitation que par absorption.

Une technique de mesure faisant appel à la photo-excitation est décrite dans une publication intitulée "New developments in CO2 Laser photoacoustic monitoring of trace gases" A. Thöny and M.W. Sigrist, Infrared Phys. Technol.. Vol. 36, No 2, pp 585-615 (1995). La mesure par absorption a notamment fait l'objet d'un papier intitulé "Near-infrared diode lasers monitor molecular species", D. Cooper and U. Martinelli, paru dans Laser focus world, November 1992.

## Revendications

1. Laser semi-conducteur, de type unipolaire, émettant dans une bande comprise dans l'infrarouge, comportant un substrat et un empilement de couches qui définissent ensemble:
• une région de gain (16) comprenant au moins:
- une zone active (26) avec au moins un puits quantique permettant des transitions inter-sous-bandes de porteurs de charge susceptibles de générer des photons de lumière cohérente, et
- une zone d'injection (28) attenante à la zone active,
• deux couches de confinement optique (18) entre lesquelles ladite région de gain (16) est interposée et qui définissent ensemble un guide d'ondes, et
• deux électrodes (10, 25), disposées aux extrémités respectives de l'empilement,
**caractérisé en ce que** ladite région de gain (16) comporte, en outre, deux plans de dopage, l'un de type p (30p), donneur de trous ou receveur d'électrons et l'autre de type n (30n), donneur d'électrons ou receveur de trous, disposés de part et d'autre de la zone active (26), le plan de dopage du type donneur étant intercalé entre la zone active et la zone d'injection.

2. Laser selon la revendication 1, **caractérisé en ce que** la région de gain (16) comporte une pluralité de zones actives (26) et de zones d'injection (28), disposées en alternance et définissant une structure en cascade dans laquelle chaque zone active est interposée entre un plan de dopage de type n (30n) et un plan de dopage de type p (30p).

3. Laser selon la revendication 2, **caractérisé en ce que** chaque zone active (26) est formée de strates définissant un superréseau comportant une alternance de barrières (34) et de puits (32) quantiques.

4. Laser selon la revendication 3, **caractérisé en ce que** :
- le substrat (10) est en phosphure d'indium InP,
- les couches de confinement (14, 18) sont en un alliage InGaAs d'arséniure d'indium InAs et d'arséniure de gallium GaAs,
- les strates de la région active définissant les barrières sont en un alliage AlInAs d'arséniure d'aluminium AlAs et de InAs, et
- les strates définissant les puits sont en InGaAs.

5. Laser selon la revendication 4, **caractérisé en ce que** l'alliage de InGaAs comporte une proportion de 52% molaire de InAs et 48% de GaAs, alors que l'alliage de AlInAs comporte une proportion de 53% molaire de InAs et 47% de AlAs.

6. Laser selon l'une quelconque des revendications précédentes, **caractérisé en ce que** les plans de dopage de type n (30n) et p (30p) comportent respectivement, comme dopant, du silicium et du béryllium ou du carbone.

7. Laser selon la revendication 6, **caractérisé en ce qu'**il comporte, sur le substrat, un empilement selon l'ordre suivant
• plan dopé de type n (30n),
• zone active (26),
• plan dopé de type p (30p),
• zone d'injection (28).

8. Laser selon l'une quelconque des revendications précédentes, **caractérisé en ce que** la couche de confinement (18) se trouvant du côté opposé au substrat (10) est recouverte d'une zone tampon (22) en AlInAs, à faible indice de réfraction.

9. Laser selon l'une quelconque des revendications précédentes, **caractérisé en ce qu'**il comporte, en outre, entre chacune des couches de confinement optique (14, 18) et l'électrode (10, 25) qui lui est contiguë, une région de gradation (12, 20, 24) formée d'une alternance de barrières et de puits dont les épaisseurs sont modulées.

10. Laser selon l'une quelconque des revendications précédentes, **caractérisé en ce que** l'une des couches de confinement (18) comporte un réseau périodique de découpes ayant un pas égal à un multiple de la moitié d'une longueur d'onde comprise dans la bande passante de la lumière émise dans la zone active, lesdites découpes étant obturées au moyen d'un métal.

11. Laser selon la revendication 10, **caractérisé en ce que** ledit métal est formé d'une couche de titane recouverte d'une couche d'or et constitue une partie de l'une desdites électrodes.

12. Laser selon l'une quelconque des revendications 1 à 9, **caractérisé en ce que** l'une desdites couches (18) de confinement optique comporte un réseau périodique de découpes ayant un pas égal à un multiple de la moitié d'une longueur d'onde comprise dans ladite bande, lesdites découpes étant obturées au moyen d'un diélectrique.

13. Laser selon la revendication 12, **caractérisé en ce que** ledit diélectrique est choisi parmi le phosphure d'indium et le nitrure de silicium.

14. Laser selon l'une quelconque des revendications précédentes, **caractérisé en ce que** les porteurs de charge sont des électrons.

## Patentansprüche

1. Einpoliger Halbleiterlaser, der innerhalb des Infrarotbereichs lasert und über ein Substrat und einen Stapel mehrerer Schichten verfügt, die gemeinsam:
• Einen Verstärkungsbereich (16), mit mindestens:
- Einem aktiven Bereich (25) mit mindestens einem Quantenwell, der intersubband-Übergänge von Ladungsträgern ermöglicht, die Photonen kohärenten Lichts erzeugen sollen, und
- Einen an den aktiven Bereich angrenzende Injektionszone (28),
• Zwei optische Einschlussbereiche (18), zwischen denen der besagte Verstärkungsbereich (16) liegt und die gemeinsam einen Wellenleiter beschreiben, und
• Zwei Elektroden (10, 25), die an den jeweiligen Enden des Stapels liegen, beschreiben,
**dadurch gekennzeichnet, dass** der besagte Verstärkungsbereich (16) unter anderem über zwei Dotierungspläne verfügt, einer des Typs p (30p), der Geber von Löchern oder Empfänger von Elektronen ist und der andere des Typs n (30 n), der Geber von Elektronen oder Empfänger von Löchern ist, die an beiden Seiten des aktiven Bereichs (26) liegen, wobei der Dotierungsplan des Typs Geber zwischen dem aktiven Bereich und der Injektionszone liegt.

2. Laser nach Anspruch 1, **dadurch gekennzeichnet, dass** der Verstärkungsbereich (16) über mehrere abwechselnde aktive Zonen (26) und Injektionszonen (28) verfügt, die eine Kaskadenstruktur beschreiben, in der die aktive Zone zwischen dem Dotierungsplan des Typs n (30n) und dem Dotierungsplan des Typs p (30 p) liegt.

3. Laser nach Anspruch 2, **dadurch gekennzeichnet, dass** jede aktive Zone (26) aus Schichten gebildet ist, die ein übergeordnetes Netz bilden, das abwechselnd aus einer Sperrschicht (34) und einem Quantenwell (32) zusammengesetzt ist.

4. Laser nach Anspruch 3, **dadurch gekennzeichnet, dass**:
- Das Substrat (10) aus Indiumphosphid InPh besteht,
- Die Einschlussbereiche (14, 18) aus einer Indiumarsenlegierung InGaAs aus Indiumarsen InAs und Galliumarsen GaAs bestehen,
- Die Schichten des aktiven Bereiches, die die Sperrschicht bilden, aus einer Legierung AlInAs aus Aluminiumarsen AlAs und aus InAs bestehen, und
- Die Schichten, die die Quantenwells bilden, aus InGaAs bestehen.

5. Laser nach Anspruch 4, **dadurch gekennzeichnet, dass** die InGaAs-Legierung über einen molaren Anteil von 52 % an InAs und von 48 % an GaAs verfügt, wobei die Legierung aus AlInAs über einen molaren Anteil von 53 % InAs und 47 % an AlAs verfügt.

6. Anspruch nach einem der vorherigen Ansprüche, **dadurch gekennzeichnet, dass** die Dotierungspläne des Typs n (30n) und p (30p) jeweils als Dotierungsstoff Silizium, Beryllium oder Kohlenstoff enthalten.

7. Laser nach Anspruch 6, **dadurch gekennzeichnet, dass** sich auf dem Substrat ein Stapel nach folgender Reihenfolge befindet:
• Dotierungsplan des Typs n (30n),
• Aktiver Bereich (26),
• Dotierungsplan des Typs p (30p),
• Injektionszone.

8. Laser nach einem der vorhergehenden Ansprüche, **dadurch gekennzeichnet, dass** sich der Einschlussbereich (18) gegenüber dem Substrat (10) befindet und mit einem Isolierbereich (22) aus AlInAs abgedeckt ist, der einen sehr geringen Brechungsindex aufweist.

9. Laser nach einem der vorhergehenden Ansprüche, **dadurch gekennzeichnet, dass** er unter anderem zwischen jedem der optischen Einschlussbereiche (14, 18) und den Elektroden (10, 25), die an ihn angrenzen, über einen Abstufungsbereich (12, 20, 24) verfügt, der abwechselnd aus Sperrschichten und Quantenwells besteht, deren Stärke geändert werden kann.

10. Laser nach einem der vorhergehenden Ansprüche, **dadurch gekennzeichnet, dass** einer der Einschlussbereiche (18) über ein Netz aus gleich großen Elementen verfügt, deren Abmessung einem Vielfachen der halben Wellenlänge des Lichts entspricht, das im Durchgangsbereich in der aktiven Zone emittiert wird, wobei die besagten Elemente des Netzes mit Metall abgeschlossen werden.

11. Laser nach Anspruch 10, **dadurch gekennzeichnet, dass** das besagte Metall aus einer Art Titanschicht besteht, die wiederum von einer Goldschicht bedeckt ist und einen Teil einer der besagten Elektroden bildet.

12. Laser nach einem der Ansprüche 1 bis 9, **dadurch gekennzeichnet, dass** eine der besagten optischen Einschlussschichten (18) über ein Netz aus gleich großen Elementen verfügt, deren Abmessung einem Vielfachen der halben Wellenlänge des Lichts entspricht, das im Durchgangsbereich in der aktiven Zone emittiert wird, wobei die besagten Elemente des Netzes mittels eines Dielektrikums abgeschlossen werden.

13. Laser nach Anspruch 12, **dadurch gekennzeichnet, dass** das besagte Dielektrikum aus Indiumphosphid und Siliziumnitrid besteht.

14. Laser nach einem der vorhergehenden Ansprüche, **dadurch gekennzeichnet, dass** die besagten Ladungsträger aus Elektronen bestehen.

## Claims

1. Semiconductor laser, of unipolar type, emitting in a band comprised within the infrared range, comprising a substrate and a stack of layers which together define:
• a gain region (16) comprising at least:
- one active zone (26) with at least one quantum well permitting inter-sub-band transitions by charge carriers liable to generate coherent light photons, and
- one injection zone (28) adjacent to the active zone;
• two optical confinement layers (18) between which said gain region (16) is placed and which together define a waveguide, and
• two electrodes (10, 25), arranged at the respective ends of the stack;
**characterized in that** said gain region (16) comprises, in addition, two doping planes, one of type p (30p), hole giver or electron receiver, and the other of type n (30n), electron giver or hole receiver, arranged on either side of the active zone (26), the doping plane of the giver type being inserted between the active zone and the injection zone.

2. Laser according to claim 1, **characterized in that** the gain region (16) comprises a number of active zones (26) and injection zones (28), arranged alternately and defining a cascade structure in which each active zone is placed between a type n doping plane (30n) and a type p doping plane (30p).

3. Laser according to claim 2, **characterized in that** each active zone (26) is formed of strata defining a superlattice comprising alternate barriers (34) and quantum wells (32).

4. Laser according to claim 3, **characterized in that**:
- the substrate (10) is of indium phosphide InP;
- the confinement layers (14, 18) are an alloy InGaAs of indium arsenide InAs and gallium arsenide GaAs;
- the strata of the active region defining the barriers are an alloy AlInAs of aluminium arsenide AlAs and InAs, and
- the strata defining the wells are of InGaAs.

5. Laser according to claim 4, **characterized in that** the InGaAs alloy comprises a proportion of 52% molar mass of InAs and 48% of GaAs, whereas the AlInAs alloy comprises a proportion of 53% molar mass of InAs and 47% of AlAs.

6. Laser according to any one of the preceding claims, **characterized in that** the doping planes of types n (30n) and p (30p) contain, as dopant, silicon and beryllium or carbon respectively.

7. Laser according to claim 6, **characterized in that** it comprises, on the substrate, a stack in accordance with the following order:
• doped plane of type n (30n)
• active zone (26)
• doped plane of type p (30p)
• injection zone (28).

8. Laser according to any one of the preceding claims, **characterized in that** the confinement layer (18) located on the side opposite the substrate (10) is covered with a buffer zone (22) of AlInAs, with a low refractive index.

9. Laser according to any one of the preceding claims, **characterized in that** it comprises, in addition, between each of the optical confinement layers (14, 18) and the electrode (10, 25) which is adjacent to it, a gradation region (12, 20, 24) formed of alternate barriers and wells the thicknesses of which are modulated.

10. Laser according to any one of the preceding claims, **characterized in that** one of the confinement layers (18) comprises a periodic lattice of cutouts with a pitch equal to a multiple of half a wavelength included in the passband of the light emitted in the active zone, said cutouts being stopped up by means of metal.

11. Laser according to claim 10, **characterized in that** said metal is formed of a layer of titanium covered with a layer of gold and constitutes part of one of said electrodes.

12. Laser according to any one of claims 1 to 9, **characterized in that** one of said optical confinement layers (18) comprises a periodic lattice of cutouts with a pitch equal to a multiple of half a wavelength included in said band, said cutouts being stopped up by means of a dielectric.

13. Laser according to claim 12, **characterized in that** said dielectric is chosen from indium phosphide and silicon nitride.

14. Laser according to any one of the preceding claims, **characterized in that** the charge carriers are electrons.
